Europäisches Patentamt

European Patent Office

Office européen des brevets

(19)

(11) Veröffentlichungsnummer: **0 478 934 A2**

## (12) EUROPÄISCHE PATENTANMELDUNG

(21) Anmeldenummer: **91113686.9**

(22) Anmeldetag: **14.08.91**

(51) Int. Cl.5: **H01L 21/20**, H01L 21/335, H01L 29/76, H01L 29/205

(30) Priorität: **19.09.90 DE 4029682**

(43) Veröffentlichungstag der Anmeldung: **08.04.92 Patentblatt 92/15**

(84) Benannte Vertragsstaaten: **DE FR GB**

(71) Anmelder: **SIEMENS AKTIENGESELLSCHAFT Wittelsbacherplatz 2 W-8000 München 2(DE)**

(72) Erfinder: **Tews, Helmut, Dr. Dipl.-Phys. Carl-Orff-Weg 1 W-8025 Unterhaching(DE)**
Erfinder: **Zwicknagl, Peter, Dr. Dipl.-Phys. Bruckenäcker 5 W-7000 Stuttgart 80(DE)**

(54) **Permeable Base Transistor mit selektiv gewachsenem Emitter.**

(57) Permeable Base Transistor, bei dem in eine Öffnung der Basisschicht (6) auf eine darunter befindliche Kollektorschicht (3) eine Emitterschicht (4, 5) oder Emitterschichtfolge aus einem Halbleitermaterial, das eine größere Energiebandlücke als das Halbleitermaterial der Basisschicht (6) hat, aufgewachsen ist.

FIG 6

EP 0 478 934 A2

Die vorliegende Erfindung betrifft einen Permeable Base Transistor für Anwendungen im Mikrowellenbereich.

Ein Permeable Base Transistor ist z. B. in dem Artikel von R.A. Murphy und J. D. Murphy: "Performance and Producibility of the GaAs Permeable Base Transistor" in Microwave Journal Juli 1987, Seiten 101 bis 116 beschrieben. Bei einem solchen Permeable Base Transistor ist eine gitterförmige Basis aus Wolfram in eine Kollektorschicht aus GaAs eingebettet. Diese Kollektorschicht ist seitlich des Basisgitters von hochohmigem GaAs-Material begrenzt, um den Stromfluß von einer ganzflächigen Emitterschicht auf den von dem Basisgitter eingenommenen Bereich zu begrenzen. Durch das Gitter wird bei Anlegen eines Potentiales der Stromfluß durch den Kollektor gesteuert. Technologische Prozesse für die Herstellung solcher Transistoren sind in der Veröffentlichung von M.A. Hollis e. a.: "Advances in the Technology for the Permeable Base Transistor" in SPIE Vol. 797, S. 335 - 347 beschrieben. Ein weiterer Übersichtsartikel ist der von C.O. Bozler: "Current Prospects for the Permeable Base Transistor" in Surface Science 174, 487 - 500 (1986).

In Vertical Channel Field Effect Transistors wird der vertikale Stromfluß im Halbleitermaterial durch beidseitig um den Kanal lateral angebrachte Metall-Gates kontrolliert. Dabei muß Vorsorge getroffen werden, daß keine elektrischen Kontakte zwischen Halbleitermaterial und den Metallelektroden des Gates entstehen.

Aufgabe der vorliegenden Erfindung ist es, einen einfach herstellbaren Permeable Base Transistor für Anwendung im Mikrowellenbereich anzugeben.

Diese Aufgabe wird mit dem Permeable Base Transistor mit den Merkmalen des Anspruches 1 gelöst. Weitere Ausgestaltungen ergeben sich aus den Unteransprüchen.

Es folgt eine Beschreibung des erfindungsgemäßen Aufbaus anhand der Figuren 1 bis 7.

Fig. 1 bis 5      zeigen den erfindungsgemäßen Transistor im Querschnitt nach fünf verschiedenen Schritten des Herstellungsverfahrens.

Fig. 6      zeigt ein Ausführungsbeispiel des erfindungsgemäßen Transistors im Querschnitt.

Fig. 7      zeigt ein alternatives Ausführungsbeispiel des erfindungsgemäßen Transistors in einer Schnittaufsicht.

Bei dem erfindungsgemäßen Permeable Base Transistor ist die Basis wie die übrigen Schichten aus Halbleitermaterial. Die Emitterschicht ist mittels selektiver Epitaxie in eine oder mehrere strukturierte Öffnungen der Basisschicht gewachsen. In diesem Transistor besteht entweder die ganze Emitterschicht oder zumindest die zuerst in die Öffnung der Basisschicht gewachsenen Anteile einer Emitterschichtfolge aus einem Halbleitermaterial mit einer gegenüber dem Halbleitermaterial der Basis größeren Energiebandlücke. Der Heteroübergang zwischen der Basisschicht und der Emitterschicht unterdrückt beim Anlegen eines Potentiales an die Basis eine Injektion von Ladungsträgern aus der Basis in den Emitterbereich in Analogie zum Heterobipolartransistor. Der leitende Emitterkanal wird durch Anlegen einer Wechselspannung an die Basis abwechselnd abgeschnürt bzw. geöffnet. Die Funktionsweise dieses Transistors ist daher mit der eines vertikalen FET vergleichbar.

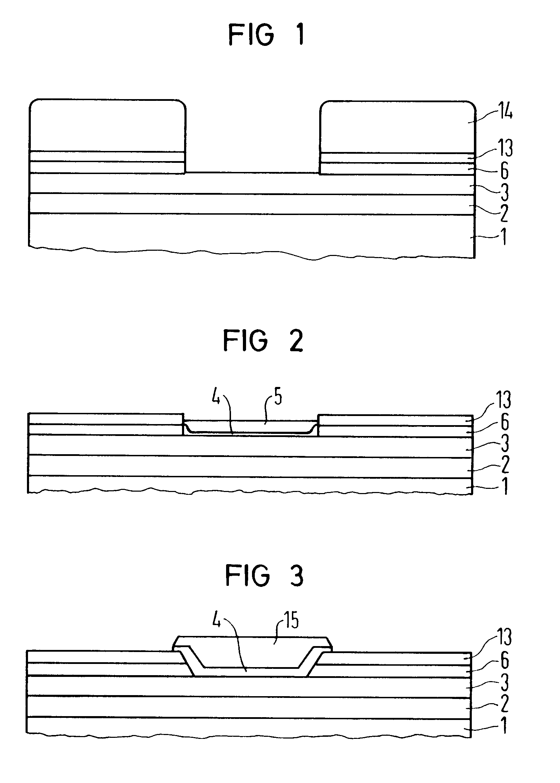

Im folgenden wird anhand der Fig. 1 bis 5 die Herstellung eines Ausführungsbeispieles beschrieben. In einem ersten Epitaxieprozeß (z. B. MBE, MOVPE, MO-MBE) werden in der dem Stand der Technik entsprechenden Weise auf ein Substrat 1 eine Subkollektorschicht 2, eine Kollektorschicht 3 und eine Basisschicht 6 aufgewachsen. Auf die Basisschicht 6 wird eine Isolatorschicht 13 (z. B. $Si_3N_4$ oder ein Oxid) ganzflächig aufgebracht und mittels einer Photolackmaske 14 naß- bzw. trockenchemisch zusammen mit der darunter befindlichen Basisschicht 6 strukturiert (Fig. 1). Die maximalen Größen der Öffnungen in der Basisschicht 6 hängen von der Wahl der Dotierungshöhe in der nachfolgend aufzuwachsenden Emitterschicht ab. Nach dem Entfernen der Photolackmaske 14 und der Reinigung der freigelegten Halbleiteroberfläche der Kollektorschicht 3 in den Öffnungen der Basisschicht 6 wird dann selektiv die Emitterschicht 4, 5 in die Öffnung der Basisschicht 6 z. B. mittels MOVPE gewachsen (Fig. 2).

Die Flanken der Öffnungen in der Basisschicht 6 können vertikal oder im Winkel verlaufen. In Fig. 2 ist der Fall senkrechter Flanken, in Fig. 3 der Fall schräger Flanken dargestellt. In Fig. 3 ist die Emitterschicht 4, 5 bis über den Rand der Isolatorschicht 13 reichend aufgewachsen.

Die Emitterschicht 4, 5 kann aus einer Schichtfolge mehrerer Einzelschichten bestehen, z. B. einer extrem dünnen Schicht 4, die unmittelbar auf die Kollektorschicht 3 aufgewachsen ist, mit einer Dicke von wenigen nm mit einem gegenüber dem Material der Basisschicht 6 sehr viel höheren Energiebandabstand (z. B. GaAs für die Basisschicht 6 und AlAs für diese erste Emitterschicht 4) und einer darauf als nächstes aufgewachsenen weiteren Schicht 5 aus einem Material mit einer besseren Leitfähigkeit (z. B. GaAs). Auf die Emitterschicht 4 bzw. Emitterschichtfolge 4, 5 kann anschließend eine Deckschicht 15 höherer Dotierung zur Herstellung eines guten Metall-Halbleiter-Kontaktes aufgewachsen werden (s. Fig. 3).

Nach dieser selektiven Epitaxie bleibt die Isolatorschicht 13 zunächst noch als Passivierungsschicht auf der Oberfläche des Halbleitermateriales. Mittels Phototechnik wird die Emittermetallisierung 8 aufgebracht. Falls die Basismetallisierung selbstjustiert zur Emittermetallisierung aufgebracht werden soll, ist es vorteilhaft, wenn die Emittermetallisierung 8 die Isolatorschicht 13 um einige Zehntel $\mu$m auf beiden Seiten überlappt. Dann wird die Isolatorschicht 13 entweder ganzflächig bis auf eine Passivierungsschicht 20 unter der Emittermetallisierung 8 oder zumindest selektiv im Bereich, der für den Basisausschluß vorgesehen ist (Strukturierung mittels Photolackmaske), entfernt.

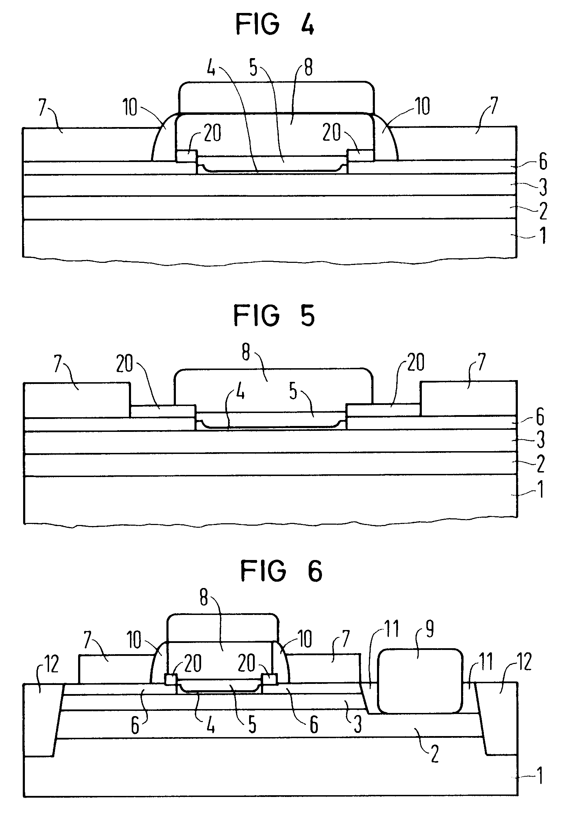

Im Fall eines selbstjustierten Emitter-Basis-Bereiches wird z. B. durch ganzflächiges Aufbringen einer weiteren Passivierungsschicht und deren Rückätzen auf beiden Seiten der Emittermetallisierung 8 ein Spacer 10 hergestellt und anschließend die Basismetallisierung 7 aufgebracht. Eine solche selbstjustierte Strukturierung des Emitter-Basis-Bereiches ist in Fig. 4 dargestellt. Eine alternative Ausführung ohne die Spacer ist in Fig. 5 dargestellt. In Fig. 5 ist die Passivierungsschicht 20 seitlich weiter bis an die Basismetallisierung 7 ausgedehnt.

Außerhalb des Emitter-Basis-Bereiches werden die Kollektorschicht 3 und die Basisschicht 6 bis mindestens an die Subkollektorschicht 2 heranreichend ausgeätzt und die Kollektormetallisierung 9 in diesem Bereich auf der Subkollektorschicht 2 aufgebracht. Die verbleibenden Öffnungen zwischen der Kollektormetallisierung 9 und dem seitlich angrenzenden Halbleitermaterial werden mit elektrisch isolierendem Material zu Isolationsbereichen 11 aufgefüllt. Die elektrischen Verbindungen der Metallisierungen (Verdrahtung, Leiterbahnen) werden in bekannter Weise ausgeführt. Bei dem Ausführungsbeispiel nach Fig. 6 ist der Transistor zusätzlich seitlich durch Trenngräben 12, die bis in das Substrat 1 hineinreichen und gegebenenfalls mit isolierendem Material gefüllt sind, begrenzt.

Die Herstellung des Emitters mittels selektiver Epitaxie in den Öffnungen der Basisschicht 6 ist auf kein spezielles Materialsystem beschränkt. Typische Materialkombinationen, die für den erfindungsgemäßen Transistor Verwendung finden können, sind z. B.:

| Basis | Emitter |
|---|---|
| | |
| $p^+$-GaAs | $N^-$-AlAs/$N^+$-AlGaAs |
| | $N^-$-AlAs/N-AlGaAs/$n^+$-GaAs |
| | $N^-$-AlAs/n-GaAs/$n^+$-GaAs |
| | $N^-$-AlAs/n-GaAs/$n^+$-grad.InGaAs/InGaAs |
| | $N^-$-AlGaAs/$n^+$-GaAs |
| | $N^-$-AlGaAs/$n^-$-GaAs/$n^+$-GaAs |
| | N-AlGaAs/$n^+$-GaAs/$n^+$-grad.InGaAs/InGaAs |
| | |
| $p^+$-InGaAs | $n^-$-InP/$n^+$-InP |
| $p^+$-Ge | N-GaAs |
| $p^+$-SiGe | n-Si/$n^+$-Si |

Es sind aber auch andere Varianten von III-V-Heterobipolar-Epischichtfolgen anwendbar.

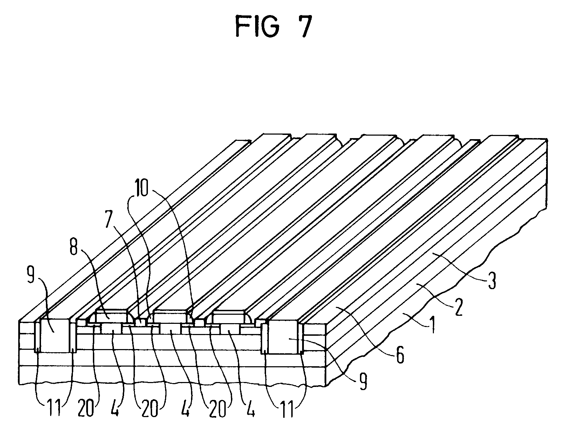

In Fig. 7 ist in einer Schnittaufsicht ein Ausführungsbeispiel eines erfindungsgemäßen Permeable Base Transistors mit drei streifenförmigen Anteilen der in die Basisschicht 6 gewachsenen Emitterschicht 4 dargestellt. Die Bezugszeichen entsprechen denen aus Fig. 6.

Im Vergleich zu einem konventionellen Heterobipolartransistor mit gleicher Emitterfläche (z. B. 5 $\mu$m$^2$) erniedrigt sich die Basis-Emitter-Fläche bei einer Basis- bzw. Emitterschichtdicke von 0,1 $\mu$m auf 1,2 $\mu$m$^2$ bei einem erfindungsgemäßen Transistor. Entsprechend reduziert sich die Basis-Emitter-Kapazität bei dem erfindungsgemäßen Aufbau.

Ein erfindungsgemäßer Transistor ist bei im übrigen gleichen Schichtaufbau und lay-out dem konventionellen Heterobipolartransistor in bezug auf die Hochfrequenzeigenschaften (kürzere Transitzeit) vor allem auch bei kleinen Strömen überlegen.

Auch im Hinblick auf höhere Stromverstärkung hat der erfindungsgemäße Transistor Vorteile. Da die Emitterschicht 4, 5 in die Basisschicht 6 eingebettet liegt, ist die Fläche für eine Oberflächenrekombination im Vergleich mit einem Heterobipolartransistor üblichen Aufbaues drastisch reduziert. Da durch den Heteroübergang an der Grenzfläche zwischen Basis und Emitter die Injektion von Ladungsträgern aus der Basis in den Emitterkanal stark unterbunden wird, ist die Wahrscheinlichkeit für eine Rekombination von Ladungsträgern im Emitter beim Durchqueren des innerhalb der Basis verlaufenden Emitterkanales klein. Beide Fakten führen zu einem erhöhten Ladungsträgertransport durch diese permeable Basis. Aufgrund der Heterogrenzfläche zwischen der Basisschicht 6 und der selektiv eingewachsenen Emitterschicht 4, 5 ergibt sich die Möglichkeit, in einem Ausführungsbeispiel die Basisschicht 6 beliebig hoch zu dotieren (sehr viel größer als $10^{19}$ cm$^{-3}$) und die Basiskontakte niederohmig auszuführen.

Der erfindungsgemäße Transistor ist ebenfalls für Leistungsanwendungen besonders gut geeignet. Da die Bedingung zur Abschnürung des Emitterkanales nur die Breite des Emitterkanals festlegt, kann die Emitterlänge groß gewählt werden. Bei dem erfindungsgemäßen Aufbau wird dadurch aber nicht wesentlich die Grenzfläche zwischen Emitter und Basis bzw. die Emitter-Basis-Kapazität erhöht.

**Patentansprüche**

**1.** Permeable Base Transistor aus Halbleitermaterialien mit einem Substrat (1) und darauf übereinander aufgewachsen einer Subkollektorschicht (2), einer Kollektorschicht (3), einer Basisschicht (6), einer in einer Öffnung dieser Basisschicht (6) auf die Kollektorschicht (3) aufgewachsenen Emitterschicht (4, 5) aus einem Halbleitermaterial, das eine größere Energiebandlücke als das Halbleitermaterial der Basisschicht (6) hat, mit einer Basismetallisierung (7) auf der Basisschicht (6), mit einer von dieser Basismetallisierung (7) elektrisch isolierten Emittermetallisierung (8) auf der Emitterschicht (4, 5) und mit einer Kollektormetallisierung (9) auf der Subkollektorschicht (2).

**2.** Transistor nach Anspruch 1,
bei dem die Emitterschicht (4, 5) aus einer Schichtfolge besteht und die unmittelbar auf der Kollektorschicht (3) aufgewachsene Schicht (4) dieser Schichtfolge eine größere Energiebandlücke hat als die nachfolgend aufgewachsene Schicht (5).

**3.** Transistor nach Anspruch 1 oder 2,
bei dem die Basisschicht (6) p$^{+}$-GaAs und die Emitterschicht (4, 5) aus einem Materialsystem aus der Gruppe von N$^{-}$-Alps/N$^{+}$-AlGaAs, N$^{-}$-AlAs/N-AlGaAs/n$^{+}$-GaAs, N$^{-}$-AlAs/n-GaAs/n$^{+}$-GaAs, N$^{-}$-AlAs/n-GaAs/n$^{+}$-grad. InGaAs/InGaAs, N$^{-}$-AlGaAs/n$^{+}$-GaAs, N$^{-}$-AlGaAs/n$^{-}$-GaAs/n$^{+}$-GaAs, N-AlGaAs/n$^{+}$-GaAs/n$^{+}$-grad. InGaAs/InGaAs ist.

**4.** Transistor nach Anspruch 1 oder 2,
bei dem die Basisschicht (6) p$^{+}$-InGaAs und die Emitterschicht (4, 5) n$^{-}$-InP/n$^{+}$-InP ist.

**5.** Transistor nach Anspruch 1 oder 2,
bei dem die Basisschicht (6) p$^{+}$-Ge und die Emitterschicht (4, 5) N-GaAs ist.

**6.** Transistor nach Anspruch 1 oder 2,
bei dem die Basisschicht (6) p$^{+}$-SiGe und die Emitterschicht (4, 5) n-Si/n$^{+}$-Si ist.

**7.** Transistor nach einem der Ansprüche 1 bis 6,
bei dem die Emitterschicht (4, 5) aus mehreren parallel nebeneinander verlaufenden und voneinander durch Anteile der Basisschicht (6) getrennte Streifen besteht.

# FIG 1

# FIG 2

# FIG 3

## FIG 4

## FIG 5

## FIG 6

FIG 7